# DEMANDE DE BREVET EUROPEEN

(11) **EP 2 014 802 A1**
(43) Date de publication de la demande: **14.01.2009**
(21) Numéro de dépôt: 08354042.7
(22) Date de dépôt: 20.06.2008
(51) Int. Cl.: C30B 11/00, C30B 29/06, C30B 29/60

(54) **Procédé d'élaboration de plaquettes en matériau semi-conducteur par moulage et cristillisation dirigée**

(30) Priorité: 29.06.2007 FR 0704690
(71) Demandeur: COMMISSARIAT A L'ENERGIE ATOMIQUE, 75015 Paris (FR)
(72) Inventeur: Drevet, Béatrice, 38000 Grenoble (FR); Sarti, Dominique, 73000 Chambéry (FR); Camel, Denis, 73000 Chambéry (FR); Garandet, Jean-Paul, 38000 Grenoble (FR)
(74) Mandataire: Jouvray, Marie-Andrée

(57) **Abrégé**

Les plaquettes en matériau semi-conducteur sont formées par moulage et cristallisation dirigée à partir d'une masse liquide (9) de ce matériau. Un germe (8), situé au fond du creuset, présente une orientation suivant des plans cristallographiques non denses. Le moule est rempli par le matériau semi-conducteur fondu (9) par l'intermédiaire d'un piston (7) ou par création d'une différence de pression dans le dispositif. Le moule (5) est, de préférence, recouvert d'un dépôt anti-adhérent non mouillable.

## Description

### Domaine technique de l'invention

L'invention est relative à un procédé d'élaboration de plaquettes en matériau semi-conducteur, par moulage et cristallisation dirigée d'une masse liquide de ce matériau, au moyen d'un dispositif comportant un creuset et un moule, constitué par une pluralité d'éléments intercalaires espacés les uns des autres, le procédé comportant l'introduction d'une charge de matériau semi-conducteur dans le creuset , sa fusion, sa solidification dirigée dans le moule, la désolidarisation du germe et du matériau semi-conducteur solidifié.

### État de la technique

Actuellement, les cellules photovoltaïques sont majoritairement fabriquées à partir de silicium monocristallin ou polycristallin. La filière de production de silicium cristallin la plus courante met en jeu la solidification de lingots à partir d'un bain de silicium liquide. Le lingot est ensuite découpé en plaquettes, qui peuvent être transformées en cellules photovoltaïques.

Une autre approche consiste à utiliser des procédés de fabrication directe de plaques de silicium (d'épaisseur typique comprise entre 100 et 500µm) par voie liquide. Ces derniers sont en grande majorité des procédés dits au défilement, c'est-à-dire des procédés dans lesquels un film de silicium liquide est tiré à partir d'un bain fondu puis solidifié. Le ruban de silicium ainsi obtenu peut être soit autosupporté, soit tiré sur un support étranger.

Le brevet JP 2947529 décrit la réalisation simultanée d'un grand nombre de plaquettes de silicium par moulage et solidification. Le remplissage par du silicium fondu du volume situé entre les différentes plaques du moule est réalisé au moyen d'un piston. La cristallinité du lingot obtenue n'est pas satisfaisante. Par ailleurs, l'utilisation d'un moule en graphite ou en quartz ne permet pas un démoulage aisé des plaquettes.

Le brevet EP0115711 décrit un procédé de préparation de plaquettes de silicium dans un creuset utilisant un moule mobile constitué par une pluralité de plaques parallèles. Un matériau additionnel ayant une température de fusion inférieure à celle du silicium et présentant une forte mouillabilité est utilisé pour éviter tout contact entre le silicium fondu et les parois du creuset et du moule. Ainsi, lors de la solidification du silicium, toute interaction parasite entre le silicium et les parois du creuset et du moule est éliminée. Une meilleure structure cristalline est ainsi obtenue. Cette approche a notamment pour inconvénient, la nécessité d'utiliser et de gérer un matériau additionnel à bas point de fusion et à forte mouillabilité. Ceci ne permet pas de réaliser des plaquettes de silicium monocristallin de manière économique. De plus, l'orientation des grains ainsi que la reproductibilité de cette orientation sont très difficilement contrôlables. En effet, dans ce cas, l'orientation des grains est uniquement contrôlée par le gradient thermique ce qui n'est pas suffisant pour obtenir une bonne cristallinité. Par ailleurs, les plaquettes de silicium doivent être nettoyées avant leur utilisation de manière à éliminer les traces du matériau additionnel sur leurs surfaces.

### Objet de l'invention

L'invention a pour objet un procédé de fabrication de plaquettes en matériau semi-conducteur ne présentant pas ces inconvénients et plus particulièrement un dispositif et un procédé faciles à mettre en oeuvre tout en assurant une bonne qualité cristallographique et en permettant des vitesses de solidification élevées.

Selon l'invention, ce but est atteint par un procédé d'élaboration selon les revendications annexées et plus particulièrement par le fait qu'un germe est disposé au fond du creuset, avant introduction de la charge et présente, après fusion de la charge, une face en contact avec la masse liquide, la face du germe ayant une orientation suivant des plans cristallographiques non denses.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 représentent, en vue schématique en coupe, un mode de réalisation du procédé selon l'invention respectivement pendant une phase de fusion et pendant une phase de solidification,
- la figure 3 représente, dans une vue schématique en coupe, une variante de réalisation du procédé selon l'invention.

### Description d'un mode préférentiel de l'invention

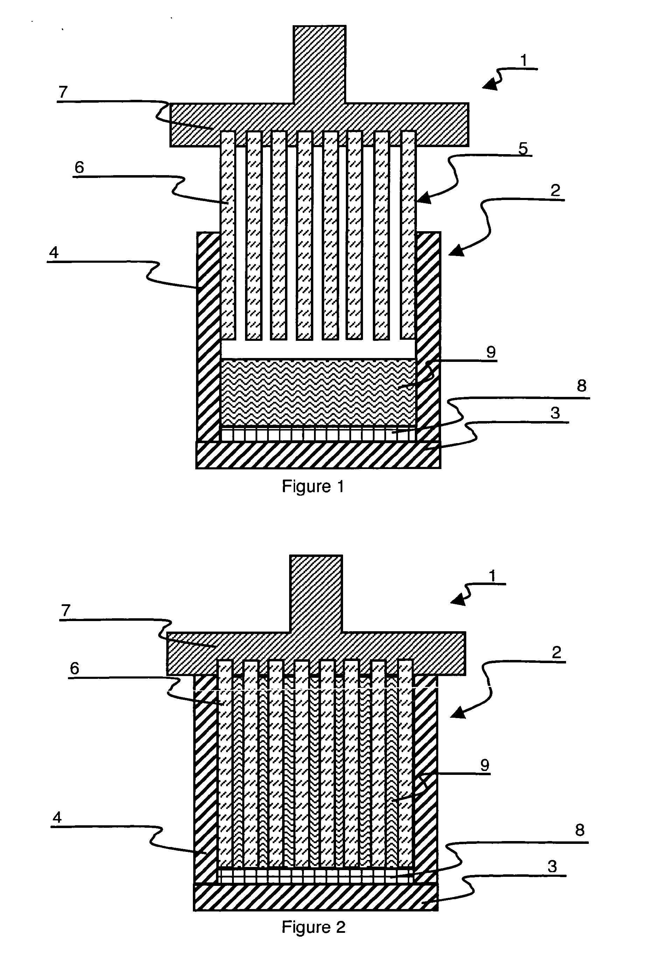

Comme illustré sur les figures 1 et 2, un dispositif 1 d'élaboration de plaquettes en matériau semi-conducteur comporte un creuset 2 ayant un fond 3 et des parois latérales 4. Le dispositif 1 comporte également un moule 5 constitué par des éléments intercalaires 6, parallèles, espacés les uns des autres et fixés à leur extrémité supérieure à un support mobile 7. Les éléments intercalaires 6 sont par exemple constitués par des plaques planes ou ayant une rainure ou des rebords correspondant aux dimensions des plaquettes en matériau semi-conducteur à former.

Un germe 8, en matériau semi-conducteur, est situé au fond du creuset 2. Une charge en matériau semi-conducteur, de préférence, de qualité microélectronique ou photovoltaïque, est placée dans le creuset 2 sur le germe 8. La charge en matériau semi-conducteur est par exemple en silicium, germanium ou un alliage de ces derniers. Avantageusement, le germe 8 est constitué dans le même matériau que la charge. Le germe 8 est sous forme monocristalline ou polycristalline, de préférence à gros grains. Le choix de la cristallinité du germe 8, monocristallin ou polycristallin, est fonction de la cristallinité désirée des plaquettes. Le germe présente avantageusement sur sa face en contact avec la charge une orientation cristalline suivant des plans cristallographiques non denses du matériau de la charge. Il peut s'agir, par exemple, pour le silicium du plan <112>

La charge en matériau semi-conducteur, par exemple en silicium, est ensuite fondue par des moyens de chauffage (non représentés), pouvant être réalisés par toute technique adaptée, tout en prenant soin de ne pas fondre le germe 8. Avantageusement, la charge est chauffée latéralement par exemple par des spires inductives. De cette manière, une phase liquide de silicium 9 est alors formée au-dessus et en contact du germe 8 et il se crée un gradient thermique entre le germe 8 et le silicium liquide 9.

Le dispositif 1 comporte également, classiquement, un système de refroidissement comportant des moyens d'extraction de la chaleur (non représentés), par exemple un système de refroidissement par circulation d'eau, avantageusement situés sous le creuset 2. Le dispositif 1 comporte encore de façon avantageuse, des moyens de réalisation du vide dans l'enceinte du dispositif (non représentés).

Le moule 5, comportant préférentiellement une pluralité d'éléments intercalaires 6, fixés sur le support mobile 7, est alors introduit dans le creuset 2. Les éléments intercalaires 6 servent à définir les dimensions des plaquettes devant être moulées. Les éléments intercalaires 6 du moule 5 permettent classiquement la réalisation simultanée d'une pluralité de plaquettes de silicium. Les plaquettes de silicium ainsi formées ont une épaisseur généralement comprise entre 100 et 500 µm. Les plaquettes peuvent être par exemple de forme rectangulaire ou carrée et ont typiquement une surface comprise entre 50x50 et 250x250 mm².

Les matériaux du moule 5 sont choisis de façon à ne pas réagir chimiquement avec le silicium fondu 9, pour limiter au minimum le risque de pollution chimique du silicium liquide 9. Les matériaux utilisés pour la réalisation du moule 5, y compris les éléments intercalaires 6, sont par exemple le graphite ou d'autres céramiques comme l'alumine, le nitrure de silicium ou le carbure de silicium. Ces matériaux sont avantageusement revêtus sur leur surface d'un dépôt anti-adhérent vis-à-vis du silicium (non représenté). Ce dépôt anti-adhérent peut être par exemple un dépôt à base de poudre de nitrure de silicium dont la méthode de réalisation est décrite notamment par Hide (« Mould Shaping Silicon Crystal Growth With a Mould Coating Material by the Spinning Method » Journal of Crystal Growth 79 (1986) 583-589) et Saito (A New Directional Solidification Technique For Polycristalline Solar Grade Silicon » XV IEEE Photovoltaic Specialists Conference, 1981, p. 576). Avantageusement, le creuset 2 peut être recouvert par le même dépôt anti-adhérent. Ce type de revêtement présente l'intérêt de permettre la réutilisation du moule 5 pour la fabrication ultérieure d'autres plaquettes de silicium.

Par ailleurs, les éléments intercalaires 6 du moule 5 sont avantageusement réalisés dans un matériau plus conducteur thermiquement que le silicium, par exemple en graphite.

De manière conventionnelle, le moule peut être rempli par le silicium fondu 9 au moyen d'un piston. A titre d'exemple, représenté à la figure 2, le piston est formé par le support 7 du moule. Ainsi, au fur et à mesure que les éléments intercalaires 6 descendent dans le creuset 2, le moule 5 est rempli par le silicium fondu 9. Le remplissage du moule 5 est terminé lorsqu'il est complètement immergé dans le silicium liquide 9. Préalablement à son introduction dans le silicium liquide 9, le moule 5 est préférentiellement chauffé à une température supérieure à la température de fusion du silicium.

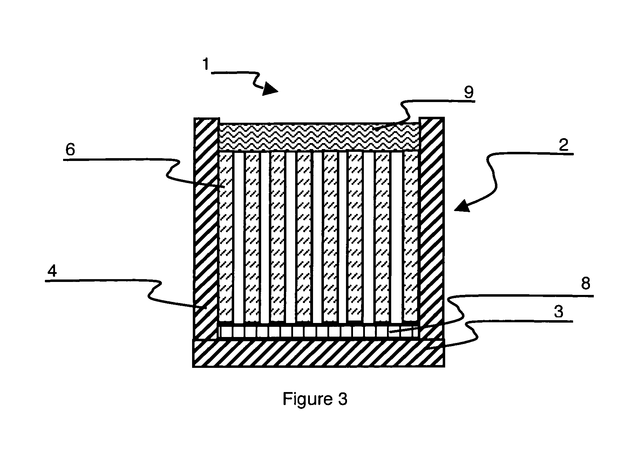

Dans une variante de réalisation, illustrée à la figure 3, le moule 5 est d'abord amené dans le creuset 2 au contact direct du germe 8 et la charge de matériau semi-conducteur est initialement disposée au-dessus des éléments intercalaires 6 du moule 5. Le remplissage du moule 5 par le silicium fondu 9 est alors obtenu en créant une différence de pression au sein du dispositif 1, par exemple, en appliquant une surpression de gaz sur la surface libre du bain de silicium fondu 9 ou par une aspiration depuis le fond des éléments intercalaires 6.

Tout au long de cette phase de remplissage du moule 5, le gradient thermique existant entre le silicium en phase liquide 9 et le germe 8 est contrôlé de façon à maintenir le germe 8 en phase solide.

Lorsque le silicium fondu 9 remplit le moule 5, le silicium est solidifié, de façon dirigée à faible vitesse, typiquement dans une gamme comprise entre 0,01 et 1 cm/min, de façon à obtenir une bonne qualité cristalline. La solidification dirigée peut être réalisée par déplacement du système de chauffage et/ou de refroidissement contrôlé. Le système de refroidissement permet d'évacuer le flux de chaleur de façon unidirectionnelle dans le plan des plaquettes de silicium, perpendiculairement à la surface du germe 8. L'utilisation d'une extraction de la chaleur de façon unidirectionnelle permet de minimiser les contraintes thermomécaniques et d'obtenir un front de solidification macroscopiquement plan conduisant à une structure de grains colonnaires si le germe 8 est polycristallin.

Les éléments intercalaires 6 étant formés dans un matériau plus thermiquement conducteur que le silicium, la chaleur des plaquettes est extraite latéralement et transmise au fond 3 du creuset 2 par l'intermédiaire des éléments intercalaires 6. Si la charge de silicium contient très peu d'impuretés, la vitesse de solidification reste inférieure à la vitesse critique de déstabilisation morphologique du front solide/liquide. Dans ces conditions, la vitesse de solidification maximale est uniquement limitée par la capacité d'extraction du flux de chaleur du dispositif 1. L'utilisation d'un moule présentant des éléments intercalaires plus thermiquement conducteurs que le silicium augmente la capacité d'extraction du flux de chaleur par rapport à une cristallisation en lingot. Ainsi, à qualité cristalline du silicium identique, l'utilisation d'un germe 8 associé à un moule 6 permet d'utiliser une vitesse de solidification plus rapide que par un procédé de cristallisation d'un lingot à partir d'un germe.

L'utilisation d'un germe 8 présentant sur sa surface supérieure une orientation suivant des plans cristallographiques non denses conduit à une surfusion de croissance du silicium plus faible par comparaison avec un germe 8 orienté suivant des plans denses. Ainsi, un germe 8 orienté suivant des plans cristallographiques non denses permet d'utiliser des vitesses de solidification plus rapides, tout en limitant la surfusion du liquide à une valeur plus faible que celle qui entraîne une germination hétérogène en avant du front de solidification et donc une croissance équiaxe.

Pendant la cristallisation du silicium entre les éléments intercalaires 6, la dimension réduite de l'espace entre les éléments intercalaires 6 constituant l'élément de moulage ne permet pas un bon brassage du silicium liquide 9. Ainsi, la ségrégation des espèces notamment les espèces dopantes est limitée. Il en résulte que le long de la direction (verticale) de solidification, la distribution par exemple des dopants par exemple du phosphore est plus homogène qu'avec la plupart des autres techniques notamment lors de la cristallisation d'un lingot. Ce dispositif est donc bien adapté à la réalisation de plaquettes de silicium avantageusement dopées de type n.

Après leur solidification, les plaquettes de silicium sont solidaires du germe 8. Elles sont alors désolidarisées du germe, par exemple par découpe au laser. Ainsi le germe 8 peut être réutilisé pour la formation de nouvelles plaquettes de silicium. Après leur libération du germe 8, les plaquettes sont directement utilisables, éventuellement après élimination d'une partie du revêtement anti-adhérent collé à leur surface.

## Revendications

1. Procédé d'élaboration de plaquettes en matériau semi-conducteur, par moulage et cristallisation dirigée d'une masse liquide de ce matériau (9), au moyen d'un dispositif (1) comportant un creuset (2) et un moule (5), constitué par une pluralité d'éléments intercalaires (6) espacés les uns des autres, le procédé comportant l'introduction d'une charge de matériau semi-conducteur dans le creuset (2), sa fusion, sa solidification dirigée dans le moule (5), la désolidarisation du germe (8) et du matériau semi-conducteur solidifié, procédé **caractérisé en ce qu'**un germe (8) est disposé au fond du creuset (2), avant introduction de la charge et présente, après fusion de la charge, une face en contact avec la masse liquide (9), la face du germe (8) ayant une orientation suivant des plans cristallographiques non denses.

2. Procédé selon la revendication 1, **caractérisé en ce que** le moule (5) est recouvert d'un dépôt anti-adhérent non mouillable.

3. Procédé selon l'une des revendications 1 et 2, **caractérisé en ce que** le moule (5) comporte un support mobile (7) auquel sont fixés les éléments intercalaires (6) et constituant un piston de remplissage du matériau semi-conducteur fondu (9) dans le moule (5).

4. Procédé selon l'une des revendications 1 et 2, **caractérisé en ce que** le matériau semi-conducteur fondu (9) étant initialement disposé au-dessus du moule (5), le dispositif comporte des moyens de création d'une différence de pression au sein du dispositif (1) pour remplir le moule avec le matériau semi-conducteur fondu (9)

5. Procédé selon l'une quelconque des revendications 1 à 4, **caractérisé en ce que** les éléments intercalaires (6) présentent une conductivité thermique supérieure à celle du semi-conducteur.

6. Procédé selon l'une quelconque des revendications 1 à 5, **caractérisé en ce que** les éléments intercalaires (6) sont en graphite.

7. Procédé selon l'une quelconque des revendications 1 à 6, **caractérisé en ce que** le germe (8) est de type monocristallin.

8. Procédé selon l'une quelconque des revendications 1 à 6, **caractérisé en ce que** le germe (8) est de type polycristallin.

9. Procédé selon l'une quelconque des revendications 1 à 8, **caractérisé en ce que** le matériau semi-conducteur est en silicium et/ou germanium.

10. Procédé selon l'une quelconque des revendications 1 à 8, **caractérisé en ce que** le matériau semi-conducteur est en silicium pour application photovoltaïque.

11. Procédé selon l'une quelconque des revendications 9 à 10, **caractérisé en ce que** la vitesse de solidification est comprise dans la gamme 0,01 - 1 cm/min.

12. Procédé selon l'une quelconque des revendications 9 à 11, **caractérisé en ce que** la charge de matériau semi-conducteur étant initialement disposée directement au-dessus du germe (8), le moule (5) est rempli par le matériau semi-conducteur fondu par le déplacement du moule vers le bas.

13. Procédé selon l'une quelconque des revendications 9 à 11, **caractérisé en ce que** la charge de matériau semi-conducteur étant initialement disposée au-dessus des éléments intercalaires (6) du moule (5), le moule (5) est rempli par le matériau semi-conducteur fondu par création d'une différence de pression.
